# DEMANDE DE BREVET EUROPEEN

(11) **EP 1 517 377 A1**
(43) Date de publication de la demande: **23.03.2005**
(21) Numéro de dépôt: 04104491.8
(22) Date de dépôt: 16.09.2004
(51) Int. Cl.: H01L 29/08, H01L 21/331, H01L 29/45, H01L 29/737

(54) **Transistor bipolaire**

(30) Priorité: 17.09.2003 FR 0350553
(71) Demandeur: ST MICROELECTRONICS S.A., 92120 Montrouge (FR)
(72) Inventeur: Chantre, Alain, 38180, Seyssins (FR); Martinet, Bertrand, 38000, Grenoble (FR); Marty, Michel, 38760, Saint Paul de Varces (FR); Chevalier, Pascal, 38530, CHAPAREILLAN (FR)
(74) Mandataire: de Beaumont, Michel

(57) **Abrégé**

L'invention concerne un nouveau transistor bipolaire à très hautes performances dynamiques et utilisable dans un circuit intégré. Ce transistor bipolaire comporte une région d'émetteur en silicium monocristallin d'épaisseur inférieure à 50 nm. La base du transistor bipolaire est en alliage SiGe.

## Description

La présente invention concerne le domaine de la microélectronique et plus précisément un transistor bipolaire et sa réalisation.

On s'intéressera plus particulièrement ici aux transistors bipolaires utilisés comme éléments de circuits intégrés notamment susceptibles de cohabiter avec des transistors MOS dans les circuits intégrés de type Bi-CMOS.

On réalise des circuits intégrés de plus en plus performants. Pour cela il faut que tous les composants soient optimisés. Les transistors bipolaires sont utilisés à cause de leurs performances dynamiques qui permettent leur utilisation dans le domaine des très hautes fréquences, supérieures à 50 GHz.

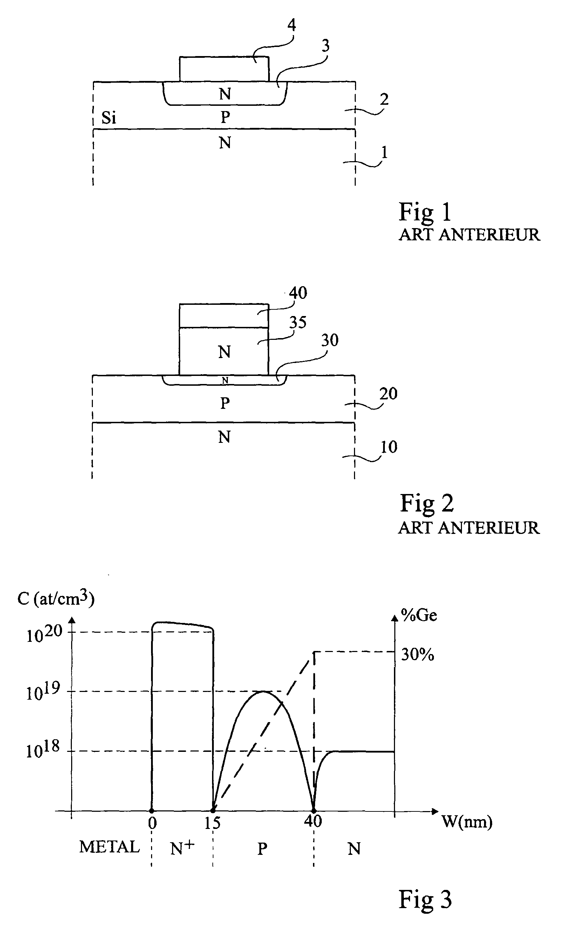

Un transistor bipolaire de type NPN classique est schématisé par la figure 1. Il comprend une région de collecteur 1 en silicium monocristallin dopé de type N, une région de base 2 en silicium monocristallin dopé de type P et une région d'émetteur 3 en silicium monocristallin dopé de type N. Le collecteur est réalisé dans un substrat de silicium, la région de base est formée au-dessus de la région de collecteur. La région d'émetteur est réalisée à l'intérieur de la région de base par exemple par diffusion d'atomes dopants. Un métal 4 est déposé sur la région d'émetteur 3 afin d'assurer un contact électrique sur cette région. Le fonctionnement de ce transistor bipolaire est le suivant. On injecte un courant de commande Ib entre la région de base et la région d'émetteur et il en résulte, selon les conditions de polarisation de la région de collecteur, un courant de collecteur Ic utilisable dans des circuits électroniques. Le courant de collecteur Ic est un courant utile et le courant de base Ib est un courant parasite. Le rapport Ic/Ib, qui est le gain en courant du transistor bipolaire, est un facteur de mérite que l'homme du métier essaye d'augmenter afin d'obtenir des valeurs supérieures à 60. De très nombreux paramètres technologiques modifient le gain du transistor bipolaire. Si le métal 4 est près de la jonction base-émetteur il crée un courant de base important en recombinant les porteurs minoritaires se situant à proximité de cette jonction. Ainsi si on veut diminuer le courant de base Ib il est nécessaire d'augmenter la distance entre le métal 4 et la région de base 2. En d'autres termes, il est nécessaire d'avoir un émetteur dont l'épaisseur est supérieure à plusieurs fois la longueur de diffusion des porteurs minoritaires se situant dans cette région d'émetteur. Ainsi, les transistors bipolaires classiques ont une épaisseur d'émetteur supérieure à 800 nm. La présence du métal n'est pas le seul paramètre influant sur le gain. Les paramètres qui modifient le gain en courant des transistors bipolaires sont très nombreux, quelquefois mal compris et souvent mal maîtrisés. Mais il a été observé qu'une augmentation de l'épaisseur de l'émetteur avait toujours pour conséquences une meilleure efficacité d'injection (augmentation de Ic) et un plus faible courant de base Ib.

Les transistors bipolaires sont souvent utilisés pour leurs performances dynamiques. Pour des raisons purement géométriques, la structure présentée par la figure 1 n'est pas très performante à cause de la capacité présente entre les régions de base et d'émetteur. Cette capacité est proportionnelle à la surface de la jonction entre la base et l'émetteur. L'émetteur s'étendant profondément dans la base, la contribution de la périphérie de l'émetteur à la capacité totale entre les régions de base et d'émetteur est importante alors que cette région, éloignée de la jonction base/collecteur, a un rôle réduit pour les courants du transistor bipolaire. Pour augmenter les performances dynamiques du transistor bipolaire, on a réalisé des transistors bipolaires à émetteur en silicium polycristallin selon la figure 2.

Le transistor de la figure 2 comprend une région de collecteur 10 en silicium monocristallin dopé de type N sur laquelle est formée une couche de base 20 en silicium monocristallin dans et sur laquelle est formée une structure d'émetteur 30-35-40. L'émetteur 35 est en silicium polycristallin dopé de type N et est prolongé, dans la région de base 20 par une région 30 diffusée de type N. Un métal 40 repose sur l'émetteur 35. L'épaisseur de la partie 30 en silicium monocristallin de l'émetteur est d'environ 100 nm et l'épaisseur de la partie 35 de l'émetteur en silicium polycristallin est d'environ 600 nm. La partie 30 de l'émetteur a une contribution prépondérante pour la capacité parasite entre l'émetteur et la région de base du transistor bipolaire. La faible profondeur de la partie 30 entraîne que cette capacité parasite est fortement réduite par rapport au cas de la figure 1, bien que l'épaisseur globale de l'émetteur soit similaire pour les cas des figures 1 et 2.

Un objet de la présente invention est de prévoir un transistor bipolaire dont les performances dynamiques sont améliorées.

Un autre objet de la présente invention est de prévoir un transistor bipolaire facilement intégrable dans un procédé Bi-CMOS.

Pour atteindre ces objets, la présente invention prévoit un transistor bipolaire comportant une première région de collecteur en silicium monocristallin d'un premier type de conductivité surmontée d'une deuxième région de base monocristalline à base de silicium et germanium d'un second type de conductivité, la région de base contenant une troisième région d'émetteur du premier type de conductivité située du côté opposé à la région de collecteur et recouverte d'un métal, dans lequel la région d'émetteur a une épaisseur inférieure à 50 nm, de préférence comprise entre 5 et 30 nm.

Selon un mode de réalisation de la présente invention, la deuxième région est constituée, à partir du collecteur, d'une première couche en SiGe dont la concentration en germanium décroît à partir d'une valeur d'environ 30 % et dopée au bore avec une concentration comprise entre 10¹⁹ et 10²⁰ at/cm³, et d'une deuxième couche en silicium d'environ 15 nm d'épaisseur.

Selon un mode de réalisation de la présente invention, le métal est du tungstène déposé sur une couche contenant du titane ou du nitrure de titane.

Selon un mode de réalisation de la présente invention, le métal est du cuivre déposé sur une couche contenant du tantale ou du nitrure de tantale.

La présente invention prévoit aussi un procédé de réalisation d'un transistor bipolaire à émetteur fin, comportant les étapes suivantes :
former par épitaxie sur un substrat monocristallin d'un premier type de conductivité une région de base d'épaisseur inférieure à 100 nm d'un second type de conductivité et comportant du germanium ;
réaliser sur le pourtour de la région de base une région fortement dopée du second type de conductivité recouverte de silicium polycristallin fortement dopé du second type de conductivité ;
réaliser dans la partie centrale de la base et à l'intérieur d'une fenêtre non recouverte par le silicium polycristallin une région d'émetteur fortement dopé du premier type de conductivité et d'épaisseur inférieure à 50 nm et de préférence comprise entre 5 et 30 nm ; et
déposer un métal au-dessus de l'émetteur.

Selon un mode de réalisation de la présente invention, le procédé d'épitaxie de la base comporte au moins deux phases conduisant à deux couches successives : une première couche constituée d'un alliage de silicium et de germanium dont la concentration en germanium décroît à partir d'une valeur d'environ 30 % et ayant une concentration d'atomes dopants comprise entre 10¹⁹ et 10²⁰ at/cm³, et une deuxième couche constituée de silicium peu dopé.

Selon un mode de réalisation de la présente invention, l'émetteur est réalisé par implantation ionique dans la fenêtre ménagée au dessus de la base dans le silicium polycristallin.

Selon un mode de réalisation de la présente invention, l'émetteur est réalisé par diffusion d'espèces dopantes contenues dans du silicium dopé à travers une couche d'oxyde natif.

Selon un mode de réalisation de la présente invention, l'étape de dépôt de métal sur l'émetteur comporte les étapes suivantes subséquentes à la diffusion de l'émetteur : graver ledit silicium dopé afin de le délimiter latéralement ; déposer un isolant recouvrant entièrement ledit silicium dopé ; ouvrir un passage à travers l'isolant débouchant sur le silicium dopé ; éliminer complètement ledit silicium dopé par le passage ; et remplir la cavité ainsi créée par un composé métallique.

Selon un mode de réalisation de la présente invention, le dépôt métallique comporte au moins deux couches, la première contenant du titane ou du tantale, la seconde contenant de l'aluminium, du tungstène ou du cuivre.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
la figure 1 représente un transistor bipolaire selon l'art antérieur ;
la figure 2 représente un autre type de transistor bipolaire selon l'art antérieur ;
la figure 3 représente un exemple de profil de dopage d'un transistor bipolaire selon la présente invention ;
les figures 4A à 4D représentent des étapes successives de fabrication d'un transistor bipolaire selon un premier mode de réalisation de la présente invention ; et
les figures 5A à 5E représentent des étapes successives de fabrication d'un transistor bipolaire selon un deuxième mode de réalisation de la présente invention.

Comme il est usuel en matière de représentation des dispositifs de circuits intégrés, les échelles ne sont pas respectées afin de mettre en évidence les différentes couches et éléments des dispositifs.

Selon la présente invention, pour augmenter les performances dynamiques d'un transistor bipolaire, la demanderesse utilise un transistor bipolaire dont l'émetteur en silicium monocristallin possède une épaisseur inférieure à 50 nm. Il est préférable pour optimiser les performances dynamiques d'utiliser une épaisseur pour la région d'émetteur comprise entre 5 et 30 nm.

Un tel transistor, par exemple de type NPN, comprend une région de collecteur en silicium monocristallin dopé de type N sur laquelle est formée par croissance épitaxiale une région de base monocristalline dans laquelle est formée une région d'émetteur. La région de base est dopée de type P par exemple avec du bore. A la surface de cette base, et à l'intérieur de celle-ci existe une région de type N fortement dopée qui constitue la région d'émetteur du transistor bipolaire. Un métal repose sur cet émetteur formant une zone de contact métallique.

Selon la présente invention la région de base est constituée de deux couches distinctes. La première couche est une matrice en silicium monocristallin épitaxiée sur la région de collecteur dans laquelle on incorpore du germanium avec un profil de concentration compris entre 0 et 30 %, un dopant de type P, par exemple du bore avec une concentration comprise entre 10¹⁹ et 10²⁰ at/cm³, et du carbone. L'épaisseur de la première couche est d'environ 30 nm. La concentration de germanium n'est pas constante, elle décroît vers la partie supérieure de la première couche. La deuxième couche est en silicium monocristallin épitaxié sur la première couche. L'épaisseur de la deuxième couche est inférieure à environ 50 nm. C'est dans au moins l'épaisseur de cette deuxième couche qu'est formé l'émetteur.

On observe qu'en associant un émetteur d'épaisseur réduite à cette structure de base les gains en courant sont supérieurs à 50, ce qui est une valeur acceptable pour les transistors bipolaires à hautes performances dynamiques. L'épaisseur réduite de l'émetteur provoque une diminution du gain en courant qui est compensée par l'augmentation de gain en courant due à la présence de germanium dans la base. On détermine le gain en courant en ajustant l'épaisseur de l'émetteur et la concentration de germanium dans la région de base.

Le choix d'une épaisseur d'émetteur inférieure à 50 nm a de nombreuses conséquences favorables pour les performances dynamiques du transistor bipolaire. A titre d'exemple on en citera trois, mais cette liste n'est pas exhaustive. Premièrement, la résistance de l'émetteur est diminuée car la région métallique est proche de la jonction base/émetteur. Deuxièmement, le temps de transit des porteurs dans l'émetteur est également diminué. Toisièmement, on limite le phénomène de stockage des porteurs minoritaires dans l'émetteur. Pendant la conduction du dispositif de nombreux porteurs minoritaires sont injectés dans l'émetteur et forment alors une charge stockée dans cet émetteur. Lorsque le transistor commute et passe à l'état bloqué il faut éliminer cette charge, ce qui n'est pas instantané puisqu'il s'agit de porteurs minoritaires. La durée de cette phase dépend du nombre de porteurs stockés et de leur durée de vie. Ces deux paramètres sont minimisés dans le transistor bipolaire selon l'invention.

Le choix d'une épaisseur d'émetteur inférieure à 50 nm a également une conséquence favorable pour les performances statiques du transistor bipolaire. Le dopage de la base n'est pas déterminé uniquement par le gain à obtenir puisque ce gain dépend aussi de l'épaisseur de l'émetteur. L'épaisseur et le dopage de la base sont déterminés de façon indépendante du gain en courant du transistor bipolaire. On choisit alors le dopage et l'épaisseur de la base en fonction des autres paramètres du transistor bipolaire, par exemple la tension de claquage entre l'émetteur et le collecteur du transistor bipolaire.

La figure 3 illustre un exemple de profil de concentration des dopants en fonction de la profondeur au niveau des jonctions émetteur/base/collecteur d'un transistor selon l'invention. On rencontre successivement quatre régions : le métal, l'émetteur monocristallin, la base et le collecteur. On a également représenté en figure 3, en pointillés, la région incorporant du germanium.

Le métal assure un contact sur l'émetteur. Son épaisseur, par exemple 200 nm, est suffisante pour limiter la résistance d'accès au dispositif. Tout métal et tout alliage métallique peuvent convenir à condition qu'ils ne pénètrent pas dans l'émetteur. Le métal est constitué, par exemple d'aluminium, de tungstène ou de cuivre. Selon le cas, des couches barrières sont utilisées, par exemple du titane et du nitrure de titane dans le cas de l'aluminium ou du tungstène, du nitrure de tantale et du tantale dans le cas du cuivre. Toute autre couche barrière et toute méthode de dépôt pour les différentes couches métalliques peuvent être utilisées.

L'émetteur est très fin et très dopé. De préférence on utilise une épaisseur inférieure à 50 nm, de préférence entre 5 et 30 nm. Le dopage, par exemple à l'arsenic, est de l'ordre de 10²⁰ at/cm³. L'épaisseur de l'émetteur est un paramètre d'ajustement du gain en courant du dispositif. Sa finesse détermine les performances électriques maximales. On peut citer un avantage apporté par un émetteur en silicium monocristallin vis-à-vis d'un émetteur en silicium polycristallin. Contrairement au cas du silicium polycristallin, la rugosité de la surface supérieure du silicium monocristallin est faible et inférieure à 3 nm. On peut contrôler durant le procédé de fabrication du transistor bipolaire l'épaisseur de l'émetteur avec une précision inférieure à 1 nm, ce qui ne serait pas réalisable dans le cas d'un émetteur en silicium polycristallin.

La base est constituée d'un alliage de SiGe contenant entre 0 et 30 % de germanium. Le profil de germanium est optimisé. De préférence, la base a une épaisseur de l'ordre de 25 nm. Le dopage, par exemple au bore, est compris entre 1019 et 10²⁰ at/cm³. Enfin du carbone est incorporé. La finesse de la base et sa faible résistance sont déterminantes pour les performances dynamiques du transistor bipolaire.

Le profil de dopage du collecteur est optimisé pour augmenter la tension de claquage de la jonction base/collecteur et pour minimiser la résistance d'accès au collecteur ainsi que le temps de transit des porteurs dans la jonction base/collecteur.

Le but proposé est atteint par ce type de transistor bipolaire. Le gain en courant est maintenu au dessus d'une valeur minimum de 50 principalement en ajustant l'épaisseur de l'émetteur et en optimisant le profil de germanium dans la base. La capacité base/émetteur est très faible car l'émetteur pénètre peu dans la base. La résistance verticale de l'émetteur est minimisée car l'épaisseur de l'émetteur est inférieure à 50 nm. Enfin le nombre de trous minoritaires injectés dans le volume de l'émetteur est réduit par la réduction du volume de l'émetteur. L'évacuation de cette charge sera très rapide en cas de commutation du dispositif. Les fréquences de fonctionnement seront améliorées. De plus le dopage de la base ainsi que le gain en courant du transistor bipolaire étant réduits, la tenue en tension entre l'émetteur et le collecteur sera améliorée et peut atteindre 5 V.

On propose deux procédés pour réaliser, suivant l'invention, des transistors bipolaires aux performances optimisées. Le premier procédé décrit la réalisation d'un transistor bipolaire dit quasi-autoaligné. Le second décrit la réalisation d'un transistor bipolaire dit autoaligné.

### Procédé quasi-autoaligné

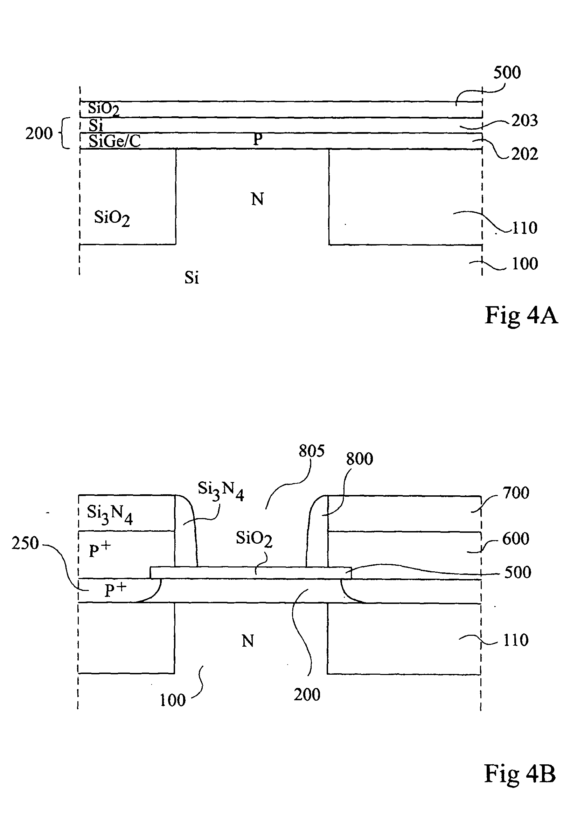

La figure 4A représente des étapes initiales de réalisation d'un transistor bipolaire quasi-autoaligné. Dans un substrat de départ 100 en silicium monocristallin de type N, on réalise des tranchées peu profondes 110 remplies d'un isolant. Ces tranchées peu profondes délimitent des zones actives débouchant à la surface du substrat. Un dépôt de la région de base 200 est réalisé sur toute la surface du substrat de telle manière qu'il soit monocristallin sur les zones actives et polycristallin au-dessus des tranchées peu profondes remplies. De préférence, ce dépôt 200 est constitué de deux couches successives 202, 203. La couche 203 est du silicium, la couche 202 est un alliage SiGe contenant du carbone et du bore. Le profil de concentration de germanium dans la couche 202 n'est pas constant, il a de préférence une forme triangulaire décroissant vers la surface. Le bore est apporté pendant l'étape de dépôt, le carbone est implanté après la réalisation de la couche 200. On dépose ensuite une couche d'oxyde 500 de 20 nm d'épaisseur sur toute la structure.

La figure 4B représente des étapes suivantes de réalisation du transistor bipolaire quasi-autoaligné. On grave la couche d'oxyde 500 de façon à laisser une pastille d'oxyde située approximativement au-dessus de la région monocristalline de la couche 200. On dépose une couche 600 de 100 nm d'épaisseur de silicium polycristallin fortement dopé, environ 10²⁰ at/cm³, au bore. On dépose alors une couche de nitrure 700 de 50 nm sur toute la structure. Les couches de nitrure 700 et de silicium polycristallin 600 sont alors gravées de façon à former une fenêtre 805 ouverte sans nitrure et sans silicium polycristallin au-dessus et à l'intérieur de la pastille d'oxyde 500. On réalise des espaceurs 800 en nitrure sur les flancs de la fenêtre 805. La largeur de ces espaceurs est par exemple de 30 nm. A ce stade, le silicium polycristallin 600 est entièrement isolé de la fenêtre 805 et en contact avec la base 200. Un recuit permet d'effectuer une diffusion du dopant du silicium polycristallin vers la région de base afin de former une région de base extrinsèque 250 fortement dopée de type P assurant le contact électrique entre la base 200 de type P et le silicium polycristallin 600 de type P. Pendant ce recuit, il se produit une diffusion du bore contenu dans la couche 202 vers la couche 203.

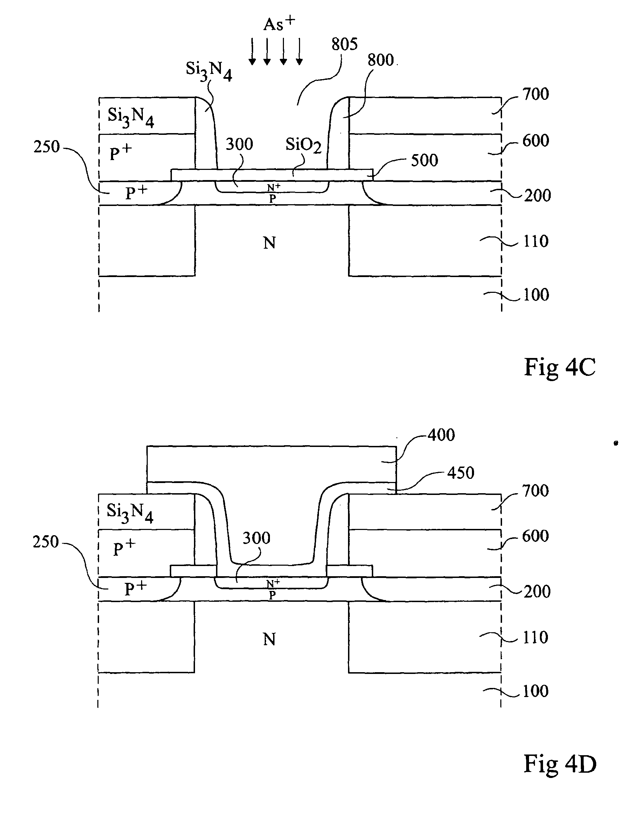

La figure 4C représente des étapes suivantes de réalisation du transistor bipolaire quasi-autoaligné. On implante dans la fenêtre 805 des ions arsenic pour créer une région 300 fortement dopée de type N dans la région de base 200, sensiblement dans la région 203 précédemment décrite. Cette implantation se fait de préférence à travers la couche d'oxyde 500. On peut effectuer également cette implantation ionique après avoir éliminé l'oxyde à l'intérieur de la fenêtre 805. L'énergie d'implantation est de l'ordre de 10 keV et la dose de l'ordre de 5.10¹⁵ at/cm².

La figure 4D représente des étapes suivantes de réalisation du transistor bipolaire quasi-autoaligné. On nettoie la fenêtre émetteur 805 et on met à nu, à l'intérieur de cette fenêtre, la surface de silicium de l'émetteur 300. On dépose une première couche métallique 450 de titane et nitrure de titane suivie d'une couche métallique 400, par exemple un alliage d'aluminium et de silicium à 2 %, puis on délimite ces couches par gravure. Dans un mode de réalisation, l'épaisseur de la couche 450 est de 20 nm, et celle de la couche 400 est de 300 nm.

### Procédé autoaligné

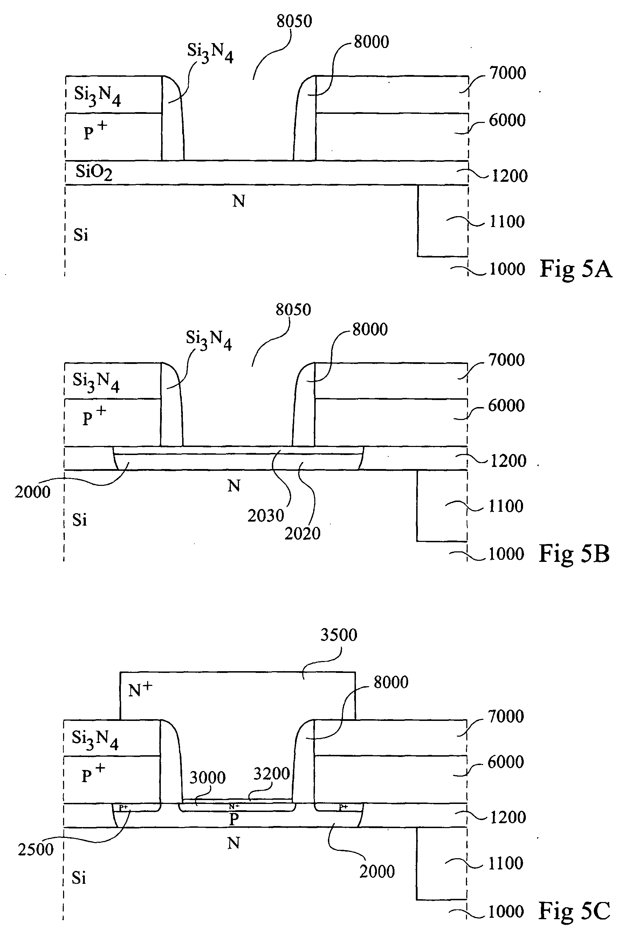

La figure 5A représente des étapes initiales de réalisation d'un transistor bipolaire autoaligné. Dans un substrat de départ 1000 en silicium monocristallin de type N, on réalise de manière classique des tranchées peu profondes 1100 remplies d'un isolant. On dépose ensuite une couche d'oxyde de silicium 1200 de 50 nm d'épaisseur. On dépose une couche 6000 de 100 nm d'épaisseur de silicium polycristallin fortement dopé de type P, environ 10²⁰ at/cm³, au bore. On dépose alors une couche de nitrure 7000 de 50 nm sur toute la structure. Les couches de nitrure 7000 et de silicium polycristallin 6000 sont alors gravées de façon à laisser une fenêtre 8050 ouverte débouchant au-dessus de la couche d'oxyde 1200. On réalise de manière classique des espaceurs 8000 en nitrure sur les flancs de la fenêtre 8050. La largeur de ces espaceurs est de 30 nm. A ce stade le silicium polycristallin 6000 est entièrement isolé de la fenêtre 8050 et du substrat 1000.

La figure 5B représente des étapes suivantes de réalisation d'un transistor bipolaire autoaligné. On grave de façon isotrope, à travers la fenêtre 8050 la couche d'oxyde 1200. On utilise par exemple une solution aqueuse contenant de l'acide fluorhydrique. Cette solution est très sélective vis-à-vis des autres couches en présence et n'attaque pratiquement pas le nitrure et le silicium polycristallin. On poursuit cette gravure isotrope de l'oxyde 1200 de façon à dégager une partie d'oxyde 1200 sous-jacente au silicium polycristallin 6000 sur le pourtour de la fenêtre 8050 et sur une distance de 200 nm environ. A ce stade, il existe une cavité dans la couche d'oxyde 1200 bornée dans sa partie inférieure par le silicium du substrat 1000, dans ses parties latérales par l'oxyde 1200 et dans ses parties supérieures par le silicium polycristallin 6000 et le nitrure 8000. On accède à cette cavité par la fenêtre 8050. On effectue alors le dépôt de la région de base 2000. De préférence ce dépôt 2000 est constitué de deux couches successives 2020, 2030. La couche 2030 est du silicium, la couche 2020 est un alliage SiGe contenant du carbone et du bore. Le profil de concentration de germanium dans la couche 2020 n'est pas constant, il a de préférence une forme triangulaire décroissant vers la surface. Le maximum de concentration du germanium est d'environ 30 %. Le bore et le carbone sont apportés pendant l'étape de dépôt. Le procédé utilisé pour le dépôt de la région de base 2000 est sélectif. La couche 2000 croît uniquement sur le substrat 1000 et sur le silicium polycristallin 6000 découverts par la cavité. C'est également un dépôt épitaxial : la région de base 2000 est monocristalline lorsqu'elle croît à partir du substrat monocristallin 1000.

La figure 5C représente des étapes suivantes de la réalisation d'un transistor bipolaire autoaligné. Un recuit permet d'effectuer une diffusion du dopant du silicium polycristallin 6000 vers la région de base 2000 sous-jacente afin de former une région de base extrinsèque 2500 fortement dopée de type P assurant le contact électrique entre la base 2000 de type P et le silicium polycristallin 6000 de type P. On dépose une couche de silicium polycristallin 3500 fortement dopée de type N avec de l'arsenic. Dans la fenêtre 8050 ce dépôt n'est pas en contact direct avec la région de base 2000 mais séparé de celle-ci par un oxyde natif 3200 d'épaisseur comprise entre 0,5 et 2 nm. Le contrôle de la qualité et de l'épaisseur de cet oxyde natif se fait par le type de nettoyage effectué avant le dépôt de la couche 3500. On grave la couche 3500 de façon à laisser un plot de silicium polycristallin dopé débordant de tous les côtés de la fenêtre 8050. Un recuit rapide de quelques dizaines de secondes à 1000°C permet la pénétration des atomes d'arsenic provenant du silicium polycristallin 3500 dans la base 2000 afin de former une région d'émetteur 3000, à travers la couche d'oxyde natif 3200.

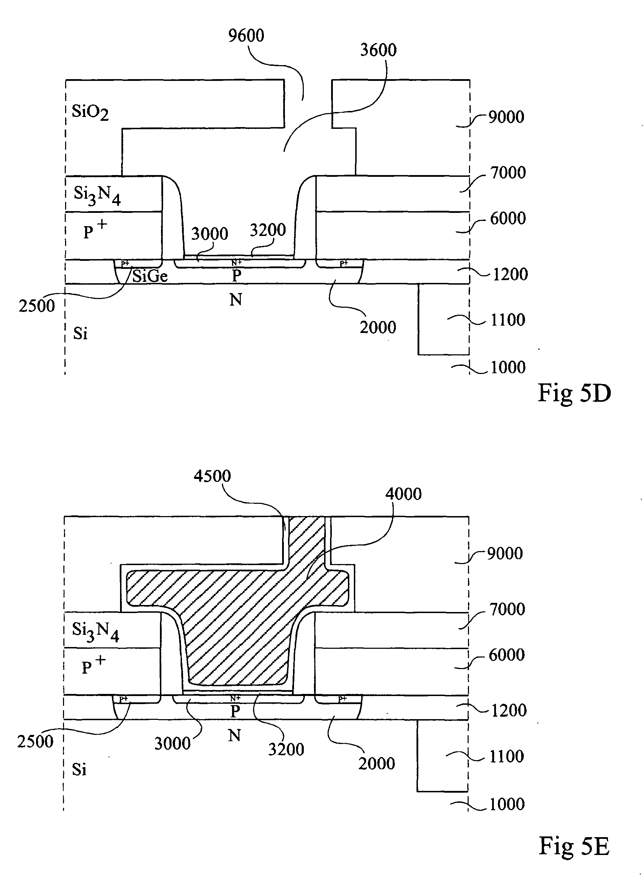

La figure 5D représente des étapes suivantes de la réalisation d'un transistor bipolaire autoaligné. On dépose un oxyde 9000 de 500 nm d'épaisseur. Une étape de planarisation permet d'obtenir une surface supérieure plane pour cet oxyde 9000. On ouvre au dessus de la couche 3500 une cheminée d'accès débouchant à la surface de cette couche 9600. Par voie chimique sélective, on élimine tout le silicium accessible en arrêtant la gravure sur la couche d'oxyde 3200. Il existe à ce stade du procédé une cavité au-dessus de la région d'émetteur bornée par l'oxyde 3200, les espaceurs en nitrure 8000, la couche d'isolation en nitrure 7000 et l'oxyde 9000. Cette cavité débouche à l'extérieur par la cheminée 9600. Dans le cas d'un circuit intégré comportant d'autres types d'éléments nécessitant de nombreuses autres étapes technologiques cette cavité peut être réalisée à la fin du procédé de fabrication et en particulier pendant l'une des étapes de réalisation des interconnexions.

La figure 5E représente des étapes suivantes de réalisation d'un transistor bipolaire autoaligné. On dépose de manière isotrope de façon classique une première couche métallique 4500 de titane et nitrure de titane dans la cavité précédemment crée. On dépose alors par une méthode de CVD (Chemical Vapor Deposition) du tungstène 4000 pour remplir de façon isotrope cette cavité. On peut également déposer de l'aluminium par une méthode ALD (Atomic Layer Déposition). On peut également réaliser un contact à base de cuivre en utilisant une couche barrière en nitrure de tantale et en faisant croître du cuivre électrolytique. Une deuxième étape de planarisation permet d'éliminer tout métal déposé au-dessus de la couche d'oxyde 9000.

Bien que divers matériaux, épaisseurs, et modes de dépôt ou de gravure aient été indiqués ci-dessus à titre d'exemple, il sera clair que l'homme de l'art pourra y apporter diverses variantes et modifications en restant dans le domaine de l'invention.

## Revendications

1. Transistor bipolaire comportant une première région de collecteur en silicium monocristallin d'un premier type de conductivité surmontée d'une deuxième région de base monocristalline à base de silicium et germanium d'un second type de conductivité, la région de base contenant une troisième région d'émetteur du premier type de conductivité située du côté opposé à la région de collecteur et recouverte d'un métal, **caractérisé en ce que** la région d'émetteur a une épaisseur inférieure à 50 nm, de préférence comprise entre 5 et 30 nm.

2. Transistor bipolaire selon la revendication 1, dans lequel la deuxième région (200, 2000) est constituée, à partir du collecteur, d'une première couche (202, 2020) en SiGe dont la concentration en germanium décroît à partir d'une valeur d'environ 30 % et dopée au bore avec une concentration comprise entre 10¹⁹ et 10²⁰ at/cm³, et d'une deuxième couche (203, 2030) en silicium d'environ 15 nm d'épaisseur.

3. Transistor bipolaire selon la revendication 1, dans lequel le métal (400, 4000) est du tungstène déposé sur une couche (450, 4500) contenant du titane ou du nitrure de titane.

4. Transistor bipolaire selon la revendication 1, dans lequel le métal (400, 4000) est du cuivre déposé sur une couche (450, 4500) contenant du tantale ou du nitrure de tantale.

5. Procédé de réalisation d'un transistor bipolaire à émetteur fin, **caractérisé en ce qu'**il comporte les étapes suivantes :
a) former par épitaxie sur un substrat monocristallin (100, 1000) d'un premier type de conductivité une région de base (200, 2000) d'épaisseur inférieure à 100 nm d'un second type de conductivité et comportant du germanium ;
b) réaliser sur le pourtour de la région de base une région fortement dopée (250, 2500) du second type de conductivité recouverte de silicium polycristallin (600, 6000) fortement dopé du second type de conductivité ;
c) réaliser dans la partie centrale de la base (200, 2000) et à l'intérieur d'une fenêtre non recouverte par le silicium polycristallin (805, 8050) une région d'émetteur (300, 3000) fortement dopé du premier type de conductivité et d'épaisseur inférieure à 50 nm et de préférence comprise entre 5 et 30 nm ; et
d) déposer un métal (450, 400, 4500, 4000) au-dessus de l'émetteur.

6. Procédé selon la revendication 5, dans lequel l'étape b) est réalisée avant l'étape a).

7. Procédé selon la revendication 5 ou 6, dans lequel le procédé d'épitaxie de la base comporte au moins deux phases conduisant à deux couches successives : une première couche constituée d'un alliage de silicium et de germanium dont la concentration en germanium décroît à partir d'une valeur d'environ 30 % et ayant une concentration d'atomes dopant comprise entre 10¹⁹ et 10²⁰ at/cm³, et une deuxième couche constituée de silicium peu dopé.

8. Procédé selon la revendication 5 ou 6, dans lequel l'émetteur est réalisé par implantation ionique dans la fenêtre (805, 8050) ménagée dans le silicium polycristallin (600, 6000) au dessus de la base (200, 2000).

9. Procédé selon la revendication 5 ou 6, dans lequel l'émetteur (300, 3000) est réalisé par diffusion d'espèces dopantes contenues dans du silicium dopé (3500) à travers une couche d'oxyde natif (320).

10. Procédé selon la revendication 9, dans lequel l'étape de dépôt de métal sur l'émetteur (300, 3000) comporte les étapes suivantes subséquentes à la diffusion de l'émetteur :
- graver ledit silicium dopé (3500) afin de le délimiter latéralement ;
- déposer un isolant (9000) recouvrant entièrement ledit silicium dopé (3500) ;
- ouvrir un passage (9600) à travers l'isolant (9000) débouchant sur ledit silicium dopé (3500) ;
- éliminer complètement ledit silicium dopé par le passage (9600) ; et
- remplir la cavité ainsi créée (3600) par un composé métallique (4500, 4000).

11. Procédé selon la revendication 5, dans lequel le dépôt métallique comporte au moins deux couches, la première (450, 4500) contenant du titane ou du tantale, la seconde contenant de l'aluminium, du tungstène ou du cuivre.
